# EUROPEAN PATENT APPLICATION

(11) **EP 1 098 351 A2**
(43) Date of publication of application: **09.05.2001**
(21) Application number: 00309327.5
(22) Date of filing: 23.10.2000
(51) Int. Cl.: H01L 21/00

(54) **Apparatus detecting misalignment of processing semiconductor wafers in a cassette and associated methods**

(30) Priority: 02.11.1999 US 431320
(71) Applicant: LUCENT TECHNOLOGIES INC., Murray Hill, New Jersey 07974-0636 (US)
(72) Inventor: Castellano Rodriguez, Antonio, Madrid 18053 (ES); Garcia Oliva, Luis Cesar, San Fernado de Henares, Madrid (ES); Gordo Banda, Manuel, Madrid 28025 (ES)
(74) Representative: Watts, Christopher Malcolm Kelway, Dr.

(57) **Abstract**

An apparatus for detecting misalignment of semiconductor wafers loaded in a chamber includes a cassette positioned in the chamber for carrying a plurality of semiconductor wafers, and a sensor positioned for detecting misalignment of at least one wafer and for generating a signal indicating misalignment thereof. The sensor is preferably an optical sensor including an optical source and an optical receiver positioned to define an optical sensing path within the chamber, the path being adjacent peripheral edges of wafers loaded in the cassette. A misaligned wafer will interrupt the optical sensing path, causing a signal indicating misalignment and interrupting operation so that the problem may be corrected. A method for semiconductor wafer handling includes the steps of positioning a plurality of semiconductor wafers in a cassette to define a loaded cassette, positioning the loaded cassette within a chamber, and sensing misalignment of at least one of the semiconductor wafers in the cassette.

## Description

### Field Of The Invention

The present invention relates to the field of manufacturing of integrated circuits and, more particularly, to handling and processing of semiconductor wafers.

### Background Of The Invention

Processing of semiconductor wafers is an essential step in the manufacture of integrated circuits, also known as ICs or simply, chips. A number of ICs may be manufactured on a semiconductor wafer, which is then cut into individual chips. Chip production involves many steps of semiconductor wafer processing, including several steps in which metals are deposited onto the wafers in a vacuum deposition chamber. One common deposition process is also known as physical vapor deposition, or sputtering. Other deposition processes include chemical vapor deposition (CVD) and plasma enhanced CVD, for example.

For sputtering, for example, semiconductor wafers are placed in a cassette for handling. The loaded cassette is positioned within a loadlock chamber in a sputtering machine. A typical cassette holds the wafers in a horizontal position with the wafers in a spaced apart relationship to define a vertically extending stack. In loading the wafers in the cassette, it is important that the wafers be properly aligned and that the wafers remain aligned when the cassette is positioned in the loadlock chamber.

A misaligned wafer may be damaged during processing and the manufacturing cycle will have to be interrupted to retrieve and replace the damaged wafer. In addition, the cause for the misalignment will have to be diagnosed and corrected, otherwise interruptions of the manufacturing process would continue.

Once the loaded cassette is positioned within the loadlock chamber, a vacuum is created within the chamber. Because the chamber is under vacuum, the machine's operator cannot easily open the chamber to correct misalignment, and wafer breakage usually requires that an entire lot of wafers be scrapped due to particle contamination. In addition, wafer breakage requires a complete cleaning of the processing apparatus to eliminate particulate contamination which may affect processing of subsequent lots of wafers. Thus, damage to wafers increases manufacturing costs due to machine downtime, loss of materials, and additional operator labor.

### Summary Of The Invention

With the foregoing in mind, it is therefore an object of the present invention to provide a semiconductor wafer processing apparatus and associated method wherein the risk of wafer breakage and the resulting losses are substantially reduced.

This and other objects, features and advantages in accordance with the present invention are provided by an apparatus including a chamber, such as a loadlock chamber, a cassette positioned in the chamber for carrying a plurality of semiconductor wafers, and a sensor for detecting misalignment of at least one wafer in the cassette and for generating a signal indicating misalignment thereof. The sensor is preferably an optical sensor including an optical source and an optical receiver. The optical source and optical receiver are preferably positioned within the chamber so that they define an optical sensing path directed so that, when a cassette loaded with wafers is properly positioned in the chamber, the path is adjacent peripheral edges of the wafers. Any misaligned wafer will interrupt the optical sensing path, causing a signal indicating misalignment and interrupting the process so that the condition may be investigated and corrected before wafer breakage occurs.

A method aspect of the invention for handling semiconductor wafers in a processing apparatus having a chamber, includes positioning a cassette loaded with a plurality of semiconductor wafers in the chamber, and optically sensing misalignment of at least one of the semiconductor wafers loaded in the cassette. The method preferably includes generating a misalignment indication, and interrupting operation of the processing apparatus responsive to sensing misalignment, so that an operator can investigate and correct the problem.

### Brief Description Of The Drawings

Some of the features, advantages, and benefits of the present invention having been stated, others will become apparent as the description proceeds when taken in conjunction with the accompanying drawings in which:
FIG. 1 is a schematic view of a cassette loaded with a plurality of semiconductor wafers; and
FIG. 2 is an enlarged schematic plan view of the cassette and sensor as shown in FIG. 1; and
FIG. 3 is a flowchart illustrating the method of the present invention.

### Detailed Description Of The Preferred Embodiments

The present invention will now be described more fully hereinafter with reference to the accompanying drawings, in which preferred embodiments of the invention are shown. This invention may, however, be embodied in many different forms and should not be construed as limited to the illustrated embodiments set forth herein. Rather, these illustrated embodiments are provided so that this disclosure will be thorough and complete, and will fully convey the scope of the invention to those skilled in the art. Like numbers refer to like elements throughout.

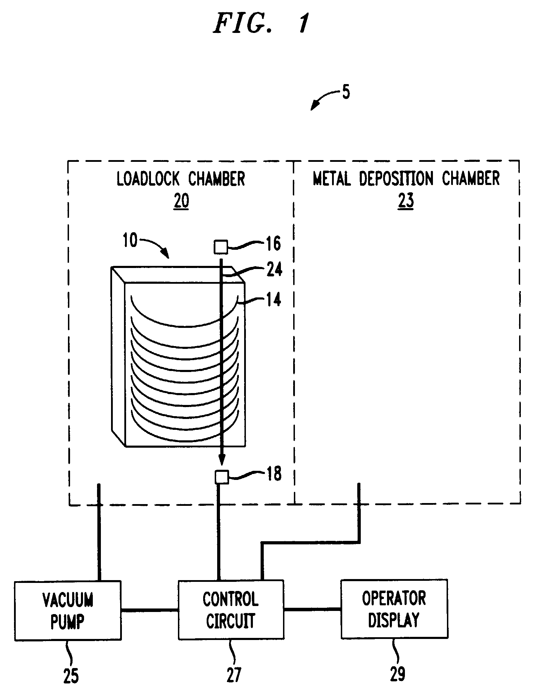

A semiconductor processing apparatus **5** in accordance with the invention is now explained with reference to FIG. 1. The apparatus **5** includes a loadlock chamber **20**, a cassette **10** positioned in the chamber and carrying a plurality of semiconductor wafers **14,** and a sensor positioned for detecting misalignment of at least one wafer **14** and generating a signal indicating misalignment thereof. The sensor is preferably operably connected to interrupt apparatus operation responsive to sensing a misaligned wafer, thereby preventing breakage of the wafer and particle contamination of the apparatus and the lot of wafers.

Metal deposition onto the wafers, takes place in a processing chamber after a high vacuum has been created therein. The semiconductor processing apparatus **5** preferably comprises a loadlock chamber **20** wherein the loaded cassette **10** is introduced into the machine in preparation for processing. The loadlock chamber **20**, as known to the skilled artisan, is generally the entry chamber wherein loaded cassettes **10** are positioned for initiating the machine's wafer processing cycle. The apparatus **5** may include other chambers in addition to the loadlock chamber **20** and the processing chamber **23**, wherein sputtering or other deposition takes place.

The sensor is preferably positioned within the loadlock chamber **20** to detect misalignment of the wafers **14** in the loaded cassette **10**. The cassette carries wafers by holding them in slots **12** arranged so as to allow wafers **14** to be vertically stacked in the cassette **10**, as shown in FIG. 1. The sensor is preferably operable under vacuum, because the chambers are generally operated under high vacuum conditions.

The sensor may be any sensor device known to those skilled in the art, but is preferably an optical sensor for optically detecting wafer misalignment. An optical sensor provides the advantage of not requiring contact with the wafers to detect misalignment, thereby not producing particles.

The optical sensor includes an optical source **16** and an optical receiver **18** cooperating therewith for detecting wafer misalignment, as shown in the illustrated embodiment. The optical source **16** and optical receiver **18** are positioned to generate an optical sensing path **24** adjacent peripheral edges of the plurality of semiconductor wafers **14**. A misaligned wafer will interrupt the sensing path **24**, allowing the sensor to thereby detect wafer misalignment. Responsive to detection of misalignment, the sensor preferably generates a misalignment signal and interrupts the operation to allow investigation and correction of the problem. In the illustrated embodiment, the cassette **10** holds the semiconductor wafers **14** in parallel spaced apart relation with respective wafer center points lying along a common axis when the wafers are properly aligned. However, those skilled in the art will appreciate that the sensor may be positioned to detect misalignment of wafers loaded in other cassette types as well.

In addition, the apparatus **5** includes a vacuum pump **25** for evacuating the chamber so that processing takes place in a vacuum environment. A control circuit **27** is connected to receive sensing information from the sensor and to control the vacuum pump **25** and interrupt processing responsive to a misalignment. The control circuit **27** is further connected to an operator display for signaling the misalignment, so that an operator may investigate and correct the problem.

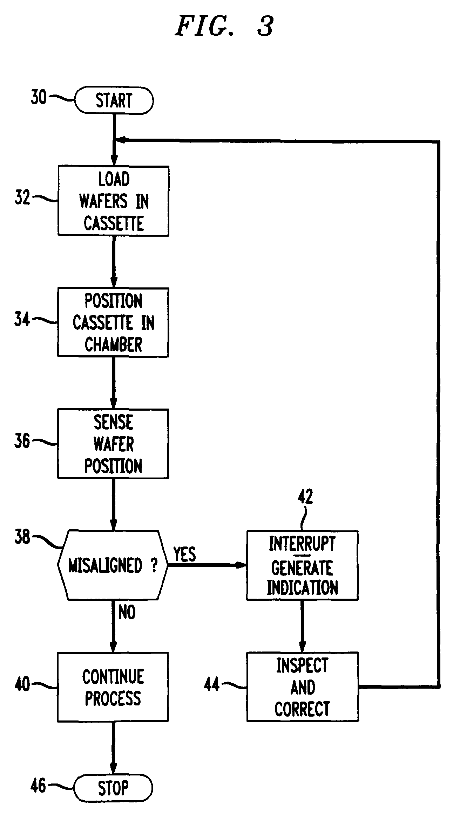

The present invention in addition includes a method **30** for semiconductor wafer handling, illustrated in the flow chart of FIG. 3. From the start (Block **30**) the method includes the steps of positioning a plurality of semiconductor wafers in a cassette at Block **32** to define a loaded cassette, positioning the loaded cassette within a chamber at Block **34**, and at Block **36** sensing misalignment of at least one of the semiconductor wafers in the cassette while the cassette is positioned within the chamber, preferably a loadlock chamber. If the sensing step detects no misalignment (Block **38**), the process continues uninterrupted (Block **40**), until stopping at Block 46.

However, the preferred method also includes the step of generating a misalignment indication responsive to the sensing step, to thereby provide a misalignment warning, and interrupting wafer handling (Block **42**) to prevent breakage and chamber contamination.

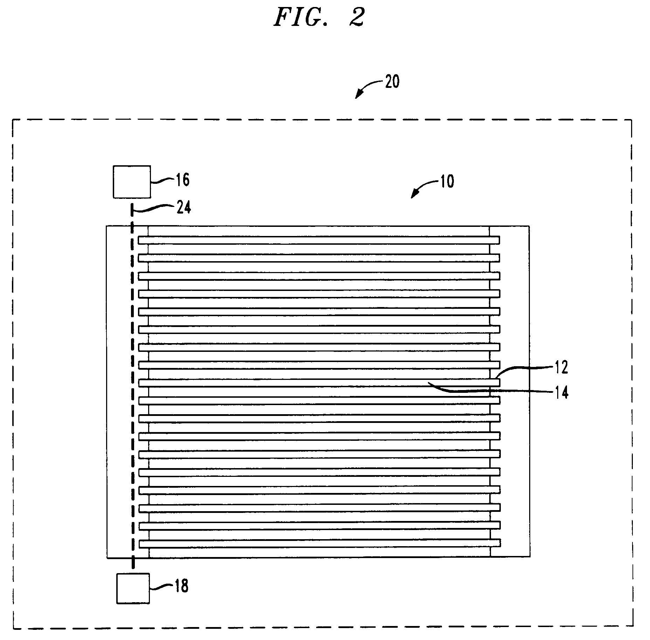

Sputter deposition of metal on a plurality of semiconductor wafers processed according to the method of the invention is a further step in another preferred embodiment of the invention. Additionally, the sensing step (Block **36**) may include optically sensing a misalignment and, particularly, optically sensing along an optical sensing path from an optical source to an optical receiver cooperating therewith, the optical path preferably adjacent peripheral edges of the plurality of semiconductor wafers, as seen in FIGS. 1 and 2. In yet another preferred method the positioning step includes positioning the wafers in parallel spaced apart relation with respective center points lying along a common axis when properly aligned, as illustrated by the cassette **10** shown in FIG. 1.

In the drawings and specification, there have been disclosed a typical preferred embodiment of the invention, and although specific terms are employed, the terms are used in a descriptive sense only and not for purposes of limitation. The invention has been described in considerable detail with specific reference to these illustrated embodiments. It will be apparent, however, that various modifications and changes can be made within the scope of the invention as described in the foregoing specification and as defined in the appended claims.

## Claims

1. A semiconductor wafer processing apparatus comprising:
a chamber;
a cassette in said chamber for carrying a plurality of semiconductor wafers; and
a sensor for detecting misalignment of at least one wafer of the plurality of wafers and for generating a signal indicating a detected misalignment carried by said cassette.

2. The apparatus of claim 1 further comprising a control circuit for controlling operation of the processing apparatus, and wherein said sensor is operably connected to the control circuit for interrupting operation of the apparatus responsive to detecting a misalignment.

3. The apparatus of claim 1 or claim 2 wherein said sensor is positioned within said chamber.

4. The apparatus of any of the preceding claims wherein said chamber comprises an evacuable chamber, and wherein said sensor is operable in a vacuum.

5. The apparatus of any of the preceding claims, wherein said chamber comprises a loadlock chamber.

6. The apparatus of claim 5 further comprising a processing chamber connected to the loadlock chamber.

7. The apparatus of claim 6, wherein the processing chamber comprises a deposition chamber.

8. The apparatus any of the preceding claims, wherein said sensor comprises an optical sensor.

9. The apparatus of claim 8, wherein the optical sensor comprises an optical source and an optical receiver cooperating therewith for detecting wafer misalignment.

10. The apparatus of claim 9, wherein said optical source and optical receiver are positioned to generate an optical sensing path adjacent peripheral edges of the plurality of semiconductor wafers.

11. The apparatus of any of the preceding claims, wherein the cassette holds the semiconductor wafers in parallel spaced apart relation with respective wafer center points lying along a common axis when the wafers are properly aligned.

12. A method for semiconductor wafer handling in a processing apparatus comprising a chamber, the method comprising the steps of:
positioning a cassette loaded with a plurality of semiconductor wafers in the chamber; and
sensing misalignment of at least one of the semiconductor wafers loaded in the cassette.

13. The method of claim 12, further comprising the step of generating a misalignment indication responsive to the sensing.

14. The method of claim 12 or claim 13, further comprising the step of interrupting operation of the processing apparatus responsive to sensing misalignment.

15. The method of any of claims 12 to 14, wherein the chamber comprises a loadlock chamber.

16. The method of any of claims 12 to 15, wherein the sensing step comprises optically sensing the misalignment.

17. The method of claim 16, wherein the step of optically sensing the misalignment comprises generating an optical sensing path from an optical source to an optical receiver cooperating therewith.

18. The method of claim 17, wherein the optical sensing path is adjacent peripheral edges of the plurality of semiconductor wafers.

19. The method of any of claims 12 to 18, further comprising the step of loading the semiconductor wafers in the cassette in parallel spaced apart relation with respective center points lying along a common axis when properly aligned.

20. The method of any of claims 12 to 19, further comprising the step of evacuating the chamber; and wherein the sensing step is carried out in the vacuum.
